Europäisches Patentamt

European Patent Office

Office européen des brevets

(19)

(11) Publication number: **0 361 779**

**A1**

(12) # EUROPEAN PATENT APPLICATION

(21) Application number: 89309587.7

(51) Int. Cl.⁵: **G01R 1/073**

(22) Date of filing: 20.09.89

(30) Priority: 26.09.88 US 249474

(43) Date of publication of application:
04.04.90 Bulletin 90/14

(84) Designated Contracting States:
**DE FR GB**

(71) Applicant: **Hewlett-Packard Company**
**3000 Hanover Street**
**Palo Alto California 94304(US)**

(72) Inventor: **Belloli, Elizabeth A.**
**236 Lassen Avenue**
**Mountain View California 94043(US)**
Inventor: **Greenstein, Michael**
**860 Covington Road**
**Los Altos California 94022(US)**
Inventor: **Burriesci, Samuel**
**722 So. Mary Avenue**
**Sunnyvale California 94087(US)**
Inventor: **Leslie, Brian**
**20357 Clifden Way**
**Cupertino California 95401(US)**
Inventor: **Matta, Farid**
**3373 Filomena Ct.**
**Mountain View California 94040(US)**

(74) Representative: **Colgan, Stephen James et al**
**CARPMAELS & RANSFORD 43 Bloomsbury**
**Square**
**London WC1A 2RA(GB)**

(54) **Micro-strip architecture for membrane test probe.**

(57) Disclosed is a system offering micro-strip architecture for an improved precision membrane test probe. A pattern of signal traces is formed on the upper side of a flexible membrane suspended by a carrier. The signal traces are connected to contact bumps; these bumps are guided to a device under test (DUT) by plating over via holes that have been bored through the membrane. Ground planes are deposited on the bottom side of the membrane opposite the signal traces. The signal traces are mounted on the membrane to face away from the (DUT), thus shielding the signal traces from inductive and capacitive coupling with the DUT. This design also prevents accidental shorting of the signal traces on the test device.

FIG._I.

# MICRO-STRIP ARCHITECTURE FOR MEMBRANE TEST PROBE

## Cross-Reference to Related Applications

This case is a Continuation based on two copending parent applications: (1) U. S. Application Serial No. 07/004,523, entitled "Test Probe" by Garrettson et al., filed on January 20, 1987, and (2) U. S. Application Serial No. 07/162,763, entitled "Membrane-Based IC TEst Probe with Precisely Positioned Contacts", by Foster et al., filed on March 1, 1988. This case also relates to a commonly assigned U.S. Patent Application entitled "Forced Delivery System for Improved Precision Membrane Probe", by Richard Huff and Brian Leslie filed in September 1988; this application is incorporated by reference (European 89307836.0)

## Background Technology

This invention relates generally to the field of semiconductor testing, and more specifically to test probes used for testing a semiconductor device under test (DUT).

Non-destructive methods for testing integrated circuits are known to people skilled in the art of semiconductor fabrication. Integrated circuits are generally grown layer by layer on thin planar substrates called wafers; many chips are formed on one wafer. Before the wafer is cut into individual chips that are then encapsulated within protective packages to create finished products, the circuitry must be inspected and checked.

Testing is usually performed while the chip circuit dies still reside together on a single wafer, since testing after the dies have been sawn apart and packaged is prohibitively expensive. Hundreds of separate chip devices on every wafer are analyzed by passing input signals into each chip device and monitoring voltage levels at selected output locations on the tiny circuits.

Conventional test probes are used to check these chip circuits while they still reside together on a wafer. These test probes often produce inaccurate results when tests are conducted using very high speed input signals. Previous test equipment incorporates a probe card that holds a flexible membrane which in turn supports a set of microst rip traces for conducting signals through a contact from a test device. This conventional tester, however, has signal traces on the same side of the membrane as the contact which touches the device under test.

However, the foregoing conventional testing technique has at least two problems.

First, the electrical test signals produced on the probe card are not shielded from electromagnetic and electrical interference caused by active electronic components residing on the test device. Capacitive and inductive coupling between the signal traces on the membrane and the circuitry on the test wafer can distort measurements taken during an examination procedure.

Second, an even more problem with a probe card is that the unshielded circuit can physically touch the input-output pads of the chip die adjacent to the chip die device under test. Besides compromising the accuracy of the test measurements, an accidental contact can damage the adjacent chip die by causing for example an electrical short circuit.

Therefore, a major challenge to designers in the semiconductor industry is to provide a highly reliable test system that can analyze integrated circuits at high speed with minimal signal or test distortion. The development of an improved test probe which could overcome this impediment would represent a major technological advance in the field of integrated circuit fabrication. The enhanced levels of quality control and test reliability that could be achieved using such an innovative device would satisfy a long felt need within the industry and would enable chip manufacturers to save substantial expenditures of time and money.

To solve these problems, the present invention offers a test system capable of delivering high speed test signals to integrated circuit chips already formed on a wafer. The design used by the inventors provides reliable test results (a) by minimizing signal distortion and (b) by preventing interference and accidental contact between a test circuit and a device under test. Although the invention is primarily intended for use as part of an automated test system, it can be used in any environment in which accurate test measurements must be obtained using high frequency test signals.

## Summary of the Invention

This invention overcomes the existing problem of high signal distortion common to high speed testing of integrated circuits. The invention can be used in conjunction with a conventional probe card held in a stationary chuck while a test wafer is stepped beneath the probe on a moving chuck.

This invention includes a flexible membrane held by a carrier. The membrane supports a pattern of electric current conducting signal traces, also called electric current paths, formed on its upper surface. A ground plane deposited on the opposite lower side of the membrane faces toward the integrated circuits residing on a wafer that require analysis. The ground plane helps reduce crosstalk between the test device and the signal traces.

Electrical contact bumps connected to the signal traces through perforations in the membrane are used to impinge upon input and output pads associated with the test device. These bumps are formed by plating through via holes in the membrane so that they protrude past the ground plane and extend in the direction of the device under test.

Placing the signal traces on the top of the membrane away from the test device greatly reduces capacitive and inductive coupling with active circuits on the test wafer. This novel design eliminates accidental shorting of the signal traces on input-output pads of the test device. Since test signal distortion caused by crosstalk is substantially decreased, the test probe can operate at a higher speed than would be possible with prior devices that are not designed to deal with this interference difficulty.

This invention provides a reliable and accurate system for analyzing circuits on an integrated circuit that will enable engineers in the semiconductor industry to construct better and more economical test equipment.

An appreciation of other aims and objectives of the present invention and a more complete and comprehensive understanding of this invention may be achieved by studying the following description of a preferred embodiment and by referring to the accompanying drawings.

### Brief Description of the Drawings

Figure 1 is a cross-section of an example construction made according to the invention defined by the Claims;

Figure 2 shows an example top view made according to the invention, revealing a radial pattern of electric signal conducting wires or traces;

Figure 3 shows a cross-section view of a portion of a signal trace formed on a membrane before the assembly has been plated with a metal to fill the via holes and form contact and ground via bumps;

Figure 4 shows the electrical contact and electrical ground via bumps protruding through the membrane of the test probe toward a device under test after the plating process; and

Figure 5 shows a ground plane after it has been deposited over a ground via.

### Detailed Description of Example Embodiments

### System Overview

The Claims define; in contrast, the Drawings, Detailed Description and Abstract illustrate an example. The Claims broadly define the invention, an invention which can be practiced using many different example structures. In contrast, the Drawings, Detailed Description and Abstract present a single specific example structure, with parts identified by reference numbers, built according to the broadlyt claimed invention.

Of all the example structures that can be made according to the Claims, the inventors consider the particular example structure discussed here to be the best example structure (i.e., the best mode) for practicing the claimed invention.

Broadly stated, this invention offers a system for establishing electrical contact with a device under test (DUT) (not shown).

The inventive membrane test probe system 10 includes a first conductor 14 and a second conductor 25. A planar means 12 is provided and has a first surface designed for being coupled to the first conductor and the second conductor. Further, planar means 12 has a second surface, and a first and a second perforation 17, 23 through itself. Planar means 12 is formed to be flexible.

Further included is a shield 16, formed to function as an electromagnetic interference minimization means, and formed to be coupled to the second surface of the planar means. A first contact means 18 is formed for being placed into contact with the device under test and formed for being electrically coupled to the first conductor 14 while substantially filling the first perforation 17 and protruding past the second surface.

A second contact means 24 is placed into contact with the device under test. Means 24 is coupled to second conductor 25 while substantially filling second perforation 23 and protruding past the second surface.

### System Details

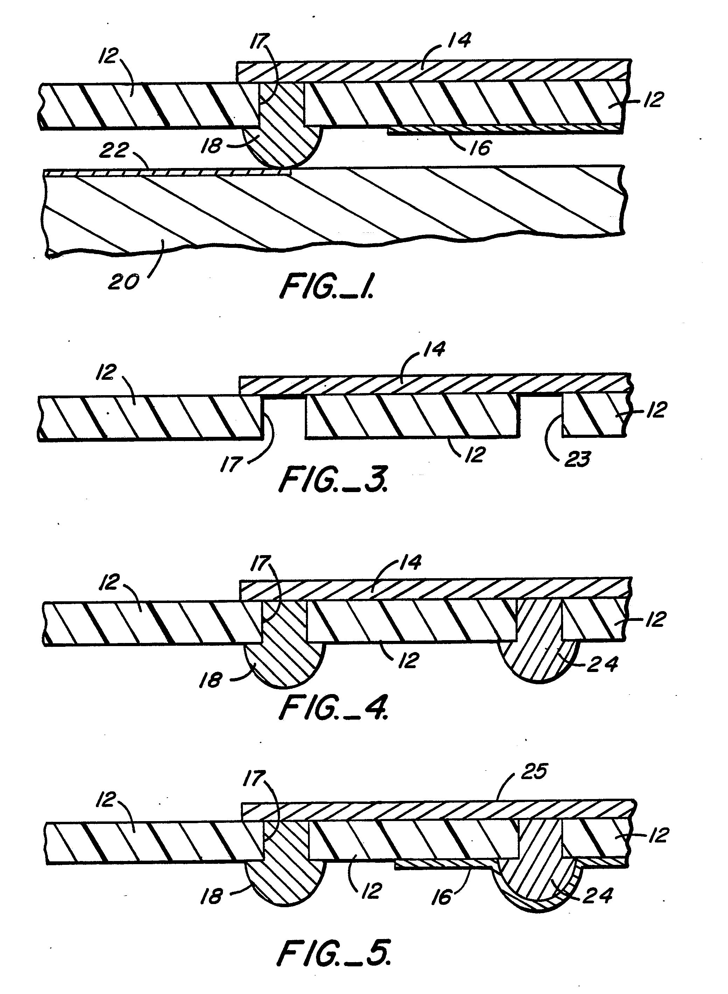

Figure 1 shows an example construction memnbrane test probe 10 in cross-section. A flexible membrane 12 is suspended by a carrier (not shown) and supports a pattern of signal traces 14 on its upper surface and a pattern of ground planes 16 on its lower surface. Via holes 17 provide channels through membrane 12 for connection to signal traces 14 and for formation of contact bumps 18.

The contact bumps 18 are guided by test probe 10 over a device under test 20. The test device 20, typically a wafer comprising a great number of integrated circuits, includes many input and output pads 22 which are the targets of contact bumps 18.

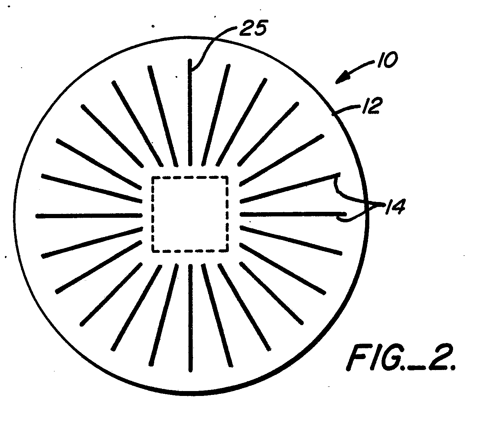

Figure 2 reveals a top plan view of the membrane 12 and signal trace pattern 14 shown in Figure 1. Figures 3, 4, and 5 illustrate progressive views of the probe 10 as it is fabricated. In Figure 3, a pattern of signal traces 14 has been formed lithographically on the upper side of perforated membrane 12. In the preferred embodiment of the present invention, an insulative polyimide material was used for the membrane 12.

The widths of the traces 14 are selected so that the required line impedance is achieved once the ground planes 16 have been added. A pattern of perforations is then produced by conventional laser micro-machining techniques using an excimer laser (not shown). Some of the perforations through the membrane 12 will be used as via holes 17 for contact bumps 18, while others will serve as ground plane via holes 23 for ground contact bumps 24.

The contact bump via holes 17 are located at the end of signal traces 14. Similarly, a second set of via holes 23 for ground planes 16 are placed where ground planes 16 must be coupled to ground contact bumps 24 and to a pattern of ground traces 25 that may be deposited on the upper surface of the membrane 12 in an alternating or interleaved configuration along with signal traces 14.

Both sets of holes 17 and 23 are then filled with a conductive metal to fabricate generally hemispherical or "mushroom" shaped protrusions that extend past the ground planes 16. During this step, the flexible membrane 12 serves as its own plating mask. The ground plane pattern 16 is then deposited on the bottom side of membrane 12 as shown in Figure 5.

This last step couples the ground bumps 24 and ground planes 16 through ground vias 23 to ground traces 25 so that common mode ground impedance is minimized. The photolithographic fabrication processes that are used to place signal and ground patterns on membrane 12 are well known to persons ordinarily skilled in the semiconductor art.

The Micro-Strip Architecture claimed below may be used in conjunction with an Improved Membrane Precision Probe that is held in a stationary chuck while a test wafer is stepped beneath the probe on a moving chuck.

Although the present invention has been described in detail with reference to a particular preferred embodiment, persons possessing ordinary skill in the art to which this invention pertains will appreciate that various modifications and enhancements may be made without departing from the spirit and scope of the claims that follow.

Claims Define the Invention

The foregoing Detailed Description gives specific details illustrating only one example of how to practice the much more broadly claimed invention. However, many other specific example structures can be made without departing from the spirit and scope of the appended Claims that follow.

Therefore it is to be understood that (a) the Detailed Description narrowly describes a single specific example construction made according to the Claims, whereas (b) the Claims actually define the invention, the invention defined has a scope much broader than the narrow scope of the specific example described above, and the scope of the claimed invention encompasses many other feasible specific example constructions and equivalent constructions in addition to the one example given above.

**Claims**

1. An apparatus for establishing electrical contact with a device under test (DUT), the apparatus comprising:

(a) a first conductor;

(b) a second conductor;

(c) a planar means:

(i) formed with a first surface designed for being coupled to the first conductor and the second conductor;

(ii) formed with a second surface;

(iii) formed to define a first perforation and a second perforation through itself;

(iv) formed to be flexible;

(d) a shield:

(i) formed to function as an electromagnetic interference minimization means; and

(ii) formed to be coupled to the second surface of the planar means;

(e) a first contact means:

(i) formed for being placed into contact with the device under test; and

(ii) formed for being electrically coupled to the first conductor while substantially filling the first perforation and protruding past the second surface; and

(f) a second contact means:

(i) formed for being placed into contact with the device under test; and

(ii formed for being electrically coupled to the second conductor while substantially filling the second perforation and protruding past the second surface.

2. A microstrip pattern and contact configuration apparatus, comprising:

(a) a membrane, formed to have:

(i) an upper side,

(ii) a lower side,

(iii) a contact bump via hole penatrating the membrane, and

(iv) a ground bump via hole penetrating the membrane;

(b) a signal trace:

(i) formed to serve as a path for an electric signal, and

(ii) formed to be coupled to the upper side of the membrane;

(c) a ground trace:

(i) formed to serve as a path for an electric signal, and

(ii) formed to be coupled to the upper side of the membrane;

(d) a ground plane, coupled to the lower side of the membrane;

(e) a contact bump, connected to the signal trace through the contact bump via hole; and

(f) a ground bump, connected to the ground trace through the ground via hole.

3. A method of fabricating an electric signal conducting pattern on a planar insulator having a first side and a second siad, the planar insulator being formed for use with an integrated circuit test probe, the method comprising the steps of:

(a) forming a first electrical pathway on a first side of a planar insulator;

(b) forming a second electrical pathway on the first side of the planar insulator;

(c) boring a first channel through to penetrate the insulator;

(d) boring a second channel through to penetrate the insulator;

(e) filling the first channel with an electric signal conducting substance;

(f) joining the conducting substance to the first electrical pathway;

(g) filling the second channel with an electric signal conducting substance;

(h) joining the conductive substance to the second electrical pathway; and

(i) forming a third electrical pathway on a second side of the planar insulator.

4. A method of manufacturing microstrip architecture for an improved precision membrane test probe, the method comprising the steps of:

(a) creating a signal trace and a ground trace lithographically on an upper portion of a membrane, the traces each having a predetermined linewidth being selected to provide desired impedance characteristics for the probe;

(b) micro-machining with a laser a contact bump via hole through the membrane, the hole being located generally at an end of the conductive trace;

(c) micro-machining with a laser a ground bump via hole through the membranethe hold being located generally at an end of the ground trace;

(d) using the membrane as a plating mask;

(e) plating the signal trace with a metal to fill the contact bump via hole and to construct a contact bump that extends from the signal trace through the membrane and protrudes beyond a lower portion of the membrane;

(f) plating the ground trace with a metal to fill the ground bump via hole and to construct a ground bump that extends from the ground trace through the membrane and protrudes beyond a lower portion of the membrane; and

(g) depositing a ground plane over the ground bump on the lower portion of the membrane.

FIG._1.

FIG._3.

FIG._4.

FIG._5.

FIG._2.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | EP-A-0 230 348  (HEWLETT-PACKARD) <br> * Abstract; page 7, lines 10-27; page 8, line 6 - page 9, line 20; figure 3 * | 1-4 | G 01 R   1/073 |
| A | DE-A-2 021 879  (IBM) <br> * Page 4, paragraphs 1,2; page 7, paragraph 1; figure 4 * | 1-4 | |
| X,P | EP-A-0 294 939  (TEKTRONIX) <br> * Column 5, line 36 - column 6, line 35; column 8, line 22 - column 9, line 19; figures 2,4 * | 1,2 | |

TECHNICAL FIELDS
SEARCHED (Int. Cl.5)

G 01 R
H 05 K
H 01 L

The present search report has been drawn up for all claims

| Place of search | Date of completion of the search | Examiner |
|---|---|---|
| THE HAGUE | 06-12-1989 | PEDERSEN H.B.B. |

EPO FORM 1503 03.82 (P0401)